# EUROPEAN PATENT SPECIFICATION

(11) **EP 4 319 199 B1**
(45) Date of publication and mention of the grant of the patent: **19.08.2026**
(21) Application number: 22775513.9
(22) Date of filing: 21.03.2022
(51) Int. Cl.: H04R 17/02, H04R 19/04, G01L 9/08, G01L 23/10

(54) **SENSOR ELEMENT AND SENSOR DEVICE HAVING SAME**
SENSORELEMENT UND SENSORVORRICHTUNG MIT DERSELBEN
ÉLÉMENT DE DÉTECTION ET DISPOSITIF DE DÉTECTION LE COMPORTANT

(30) Priority: 26.03.2021 JP 2021053403
(43) Date of publication of application: 07.02.2024
(73) Proprietor: DENSO CORPORATION, Kariya-city, Aichi-pref., 448-8661 (JP)
(72) Inventor: MAWATARI, Kazuaki, Kariya-city, Aichi-pref., 448-8661 (JP)
(74) Representative: Winter, Brandl - Partnerschaft mbB
(86) International application number: PCT/JP2022/012932
(87) International publication number: WO 2022/202726

(56) References cited:
- JP-A- 2002 250 665
- JP-A- 2004 020 757
- JP-A- 2007 124 449
- JP-A- 2017 187 446
- JP-A- 2018 170 697
- JP-U- S5 842 723
- US-B2- 7 943 413

## Description

### CROSS REFERENCE TO RELATED APPLICATIONS

The present application is based on Japanese Patent Application No. 2021-53403 filed on March 26, 2021.

### TECHNICAL FIELD

The present disclosure relates to a sensor element having a sensing section formed with a slit through which the medium to be measured can pass, and a sensor device having the same.

### BACKGROUND

Conventionally, there has been proposed a sensor element having a sensing section in which a slit is formed (see, for example, JP 5 936 154 B2). Specifically, the sensor element is a piezoelectric element, and includes a support member, a piezoelectric film disposed on the support member, and an electrode film electrically connected to the piezoelectric film. In the sensor element, a recess is formed in the support member, and a part of the piezoelectric film and the electrode film constitutes is a floating region floating from the support member. The floating region is divided into a plurality of vibration regions by slits. Such a sensor element outputs a detection signal corresponding to the applied pressure of the medium to be measured by vibrating the vibration regions. For this reason, such a sensor element includes a sensing section including the vibration regions.

JP 2018 170 697 A describes a sensor element that comprises a support member having a recess, and a sensing section configured to output a detection signal corresponding to a pressure of a medium to be measured, and being disposed on the support member and having a floating region formed by the recess. The sensing section has a slit through which the medium to be measured passes is formed in a portion exposed to the medium to be measured,

Further reference is made to JP 2017 187 446 A, JP 2007 124 449 A and US 7 943 413 B2 which have been determined as related art.

### SUMMARY

However, in the sensor element as described above, foreign matter may adhere to the slit. In such a sensor element, there is a possibility that the detection accuracy may be lowered due to foreign matter adhering to the slit.

An object of the present disclosure is to provide a sensor element capable of suppressing deterioration in detection accuracy and a sensor device including the same.

The object is solved by the subject matter of the independent claim. Preferred embodiments are described in the dependent claims.

The reference numerals in parentheses attached to the components and the like indicate an example of correspondence between the components and the like and specific components and the like in an embodiment to be described below.

### BRIEF DESCRIPTION OF THE DRAWINGS

FIG. 1 shows a configuration of a piezoelectric device according to a first embodiment;
FIG. 2 is a cross-sectional view of a piezoelectric element shown in FIG. 1;
FIG. 3 is a plan view of the piezoelectric element shown in FIG. 2;
FIG. 4 is a cross-sectional view of the piezoelectric element according to a second embodiment;
FIG. 5 is a cross-sectional view of a piezoelectric element in a modified example of the second embodiment;
FIG. 6 is a cross-sectional view of a piezoelectric device according to a third embodiment; and
FIG. 7 is a cross-sectional view of an electrostatic pressure sensor according to a fourth embodiment.

### DETAILED DESCRIPTION

Hereinafter, embodiments of the present disclosure will be described with reference to the drawings. In the following embodiments, the same reference numerals are assigned to parts that are the same or equivalent to each other to describe the same.

### (First Embodiment)

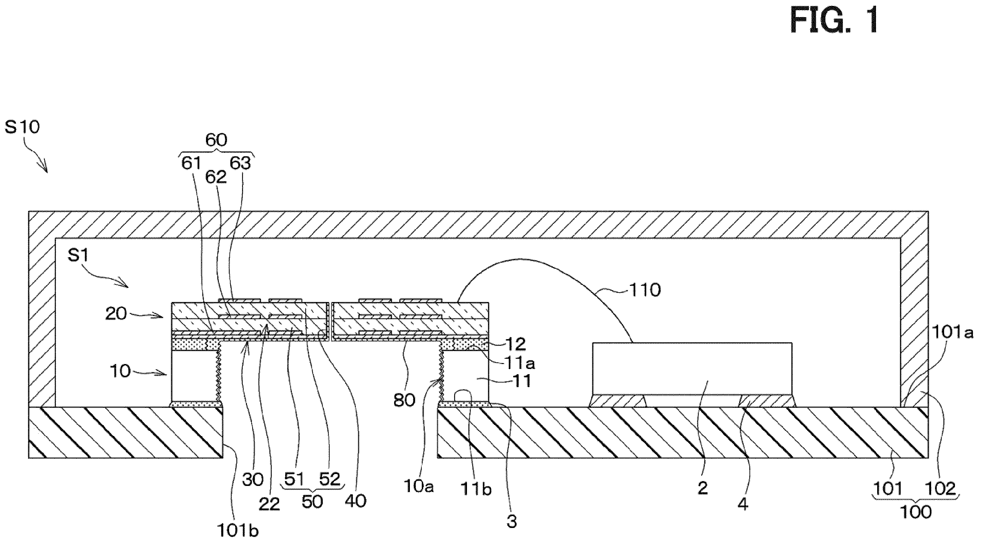

A first embodiment will be described with reference to FIGS. 1 to 3. In the present embodiment, a piezoelectric element S1 will be described as an example of a sensor element that outputs a pressure detection signal corresponding to a pressure of a medium to be measured. Moreover, in the present embodiment, a piezoelectric device S10 including the piezoelectric element S1 will be described as a sensor device. In addition, the piezoelectric device S10 of the present embodiment is preferably used to detect pressure such as sound pressure of 1 to 20000 Hz, which is an audible range, and is preferably used by being mounted on a smart phone, an AI (abbreviation of artificial intelligence) speaker, or the like. Also, the piezoelectric device S10 of the present embodiment is installed in an electronic device or the like that exhibits a wake-up function that can obtain an output according to displacement without a power source, and is preferably used to detect the displacement.

As shown in FIG. 1, the piezoelectric device S10 of the present embodiment includes a piezoelectric element S1 and a circuit board 2. The piezoelectric element S1 and the circuit board 2 are accommodated in a casing 100. First, the configuration of the piezoelectric element S1 of the present embodiment will be described.

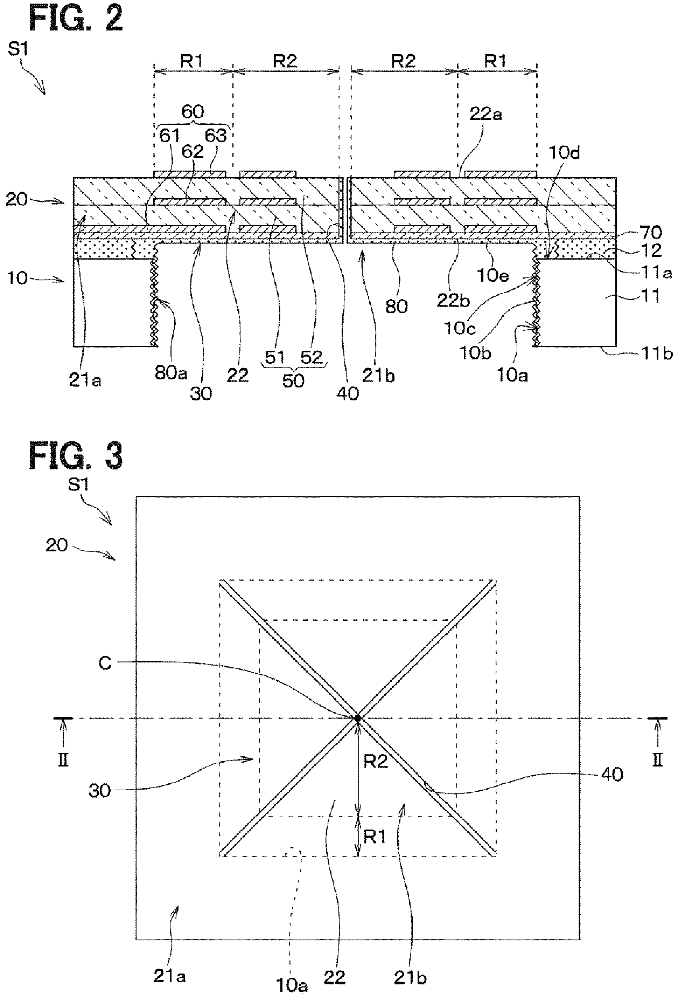

As shown in FIGS. 2 and 3, the piezoelectric element S1 includes a support member 10 and a vibrating portion 20, and has a rectangular planar shape. The support member 10 includes a support substrate 11 having one surface 11a and the other surface 11b, and an insulating film 12 formed on one surface 11a of the support substrate 11. The support substrate 11 is made of, for example, a silicon substrate, and the insulating film 12 is made of an oxide film or the like.

The vibrating portion 20 constitutes a sensing section 30 that outputs a pressure detection signal corresponding to sound pressure or the like as pressure, and is disposed on the support member 10. In the support member 10, a recess 10a is formed for floating an inner edge side of the vibrating portion 20. Therefore, the vibrating portion 20 has a structure with a support region 21a arranged on the support member 10 and a floating region 21b connected to the support region 21a and floating on the recess 10a. In the recess 10a of the present embodiment, the shape of the open end on the vibrating portion 20 side (hereinafter, also simply referred to as an open end of the recess 10a) has a rectangular shape in a plane. Therefore, the entire floating region 21b has a flat rectangular shape.

Here, the recess 10a of the present embodiment is formed by removing the insulating film 12 by isotropic wet etching after removing the support substrate 11 by anisotropic dry etching. For this reason, a side surface 10b of the recess 10a is in a state in which minute uneven portions 10c are formed. The uneven portions 10c have, for example, a surface roughness Ra of about 50 to 10000 nm. In addition, in FIG. 2, the uneven portions 10c are exaggerated for easy understanding. Also, in other corresponding drawings, the uneven portions 10c are shown in an exaggerated manner.

When the recess 10a is formed on the support member 10 as described above, the insulating film 12 is easier to remove than the support substrate 11. Therefore, a stepped portion 10d is formed at a boundary between the support substrate 11 and the insulating film 12 in the side surface 10b of the recess 10a by scraping the insulating film 12.

The floating region 21b is divided by a slit 40 so that four vibration regions 22 are formed. In the present embodiment, two slits 40 are formed so as to pass through a center C of the floating region 21b and extend toward the opposite corners of the floating region 21b. In other words, the slits 40 respectively extend to the center C from the corners of the floating region 21b with a flat rectangular shape, and intersect with each other at the center C. Thus, the floating region 21b is separated into four vibration regions 22 each having a substantially planar triangular shape. Although not particularly limited, in the present embodiment, the distance between the vibration regions 22 (that is, the width of the slit 40) is about 1 µm.

Since each vibration region 22 is configured by dividing the floating region 21b as described above, each vibration region 22 is configured as a cantilever having one end portion as a fixed end portion supported by the support member 10 (that is, the support region 21a) and the other end portion as a free end. That is, each vibration region 22 is in a state of being connected to the support region 21a and in a state of being cantilevered. The sensing section 30 of the present embodiment is configured to have each vibration region 22 and is in a state in which the slits 40 are formed. In the following description, the surface of the vibration region 22 on the opposite side from the support member 10 is defined as one surface 22a of the vibration region 22, and the surface of the vibration region 22 on the support member 10 side is defined as the other surface 22b of the vibration region 22.

The vibrating portion 20 has a piezoelectric film 50 and an electrode film 60 connected to the piezoelectric film 50. Specifically, the piezoelectric film 50 has a lower piezoelectric film 51 and an upper piezoelectric film 52 laminated on the lower piezoelectric film 51. The electrode film 60 includes a lower electrode film 61 disposed below the lower piezoelectric film 51, an intermediate electrode film 62 disposed between the lower piezoelectric film 51 and the upper piezoelectric film 52, and an upper electrode film 63 disposed on the upper piezoelectric film 52. That is, the vibrating portion 20 has a bimorph structure in which the lower piezoelectric film 51 is sandwiched between the lower electrode film 61 and the intermediate electrode film 62, and the upper piezoelectric film 52 is sandwiched between the intermediate electrode film 62 and the upper electrode film 63.

The lower piezoelectric film 51 and the upper piezoelectric film 52 are made of scandium aluminum nitride (ScAIN), aluminum nitride (AIN), zinc oxide (ZnO), lead zirconate titanate, or the like. The lower piezoelectric film 51 and the upper piezoelectric film 52 have the same crystal orientation indicating piezoelectric characteristics. The lower electrode film 61, the intermediate electrode film 62, and the upper electrode film 63 are made of molybdenum (Mo), platinum (Pt), titanium (Ti), iridium (Ir), ruthenium (Ru), or the like.

In each vibration region 22 of the present embodiment, a portion on the support region 21a side that becomes a fixed end when the vibration region 22 vibrates is a first region R1, and a portion on the center C side is a second region R2. The lower electrode film 61, the intermediate electrode film 62, and the upper electrode film 63 are formed in the first region R1 and the second region R2, respectively. Here, the lower electrode film 61, the intermediate electrode film 62, and the upper electrode film 63 formed in the first region R1 and the lower electrode film 61, the intermediate electrode film 62, and the upper electrode film 63 formed in the second region R2 are separated and insulated from each other.

The lower electrode film 61, the intermediate electrode film 62, and the upper electrode film 63 are formed so as not to reach the slits 40. That is, the lower electrode film 61, the intermediate electrode film 62, and the upper electrode film 63 are formed to terminate on the inner side of the side surface 22c exposed from the slits 40 in the vibration region 22. In other words, the lower electrode film 61, the intermediate electrode film 62, and the upper electrode film 63 are disposed on the inner side of the slits 40 in a normal direction with respect to one surface 22a and the other surface 22b.

Each electrode film 60 is appropriately connected to a wiring (not shown) formed in the support region 21a of the vibrating portion 20, and is connected to the circuit board 2 via an electrode portion (not shown) formed in the support region 21a. A wiring and electrode portions (not shown) are made of, for example, aluminum (Al), gold (Au), copper, or the like. Further, the lower electrode film 61, the intermediate electrode film 62, and the upper electrode film 63 formed in the second region R2 are not electrically connected to the electrode portions, and are in a floating state. Therefore, the lower electrode film 61, the intermediate electrode film 62, and the upper electrode film 63 formed in the second region R2 may not be always necessary. In the present embodiment, they are formed so as to protect portions of the lower piezoelectric film 51 and the upper piezoelectric film 52 arranged in the second region R2.

Further, the vibrating portion 20 of the present embodiment includes a base film 70 on which the lower piezoelectric film 51 and the lower electrode film 61 are disposed. That is, the piezoelectric film 50 and the electrode film 60 are disposed on the support member 10, with the base film 70 interposed between the piezoelectric film 50 and the electrode film 60. The slits 40 are formed so as to penetrate the base film 70 as well. The base film 70 is not necessarily required, but is provided to facilitate crystal growth when the lower piezoelectric film 51 and the like are formed. In the present embodiment, the base film 70 is made of aluminum nitride or the like. The piezoelectric film 50 has a thickness of about 1 µm, and the base film 70 has a thickness of about several tens nm. That is, the base film 70 is extremely thin with respect to the piezoelectric film 50.

Further, in the present embodiment, a protective film 80 is formed at a location including the slits 40. The other surface 22b of the vibration region 22 is referred to as a bottom surface 10e of the recess 10a and the protective film 80 is formed on the side surface 10b of the recess 10a, the bottom surface 10e of the recess 10a, and the slit 40. However, the protective film 80 arranged in the slit 40 is provided so as to maintain a state in which the medium to be measured can pass. In other words, the protective film 80 arranged in the slit 40 is provided so as not to fill the slit 40. Moreover, the protective film 80 fills the stepped portion 10d at the boundary between the side surface 10b and the bottom surface 10e of the recess 10a, and the portion located on the side surface 10b and the portion located on the bottom surface 10e are arranged so as to be connected more smoothly than the stepped portion 10d. In the present embodiment, the bottom surface 10e of the recess 10a (that is, the other surface 22b of the vibration region 22) corresponds to the pressure receiving surface, which will be specifically described later. Further, the portion of the protective film 80 formed on the side surface 10b of the recess 10a is arranged so as to form an uneven structure 80a caused by the uneven portion 10c of the side surface 10b.

The protective film 80 is selected according to the medium to be measured for pressure detected by the piezoelectric element S1. Specifically, when the medium to be measured is a gas, the protective film 80 is made of a material having higher liquid repellency than the sensing section 30 (that is, the base film 70 and the piezoelectric film 50) so that the liquid such as water contained in the gas is less likely to adhere to the vibration region 22. In addition, when the medium to be measured is a liquid such as oil, the protective film 80 is made of a material that is more lyophilic than the sensing section 30 (that is, the base film 70 and the piezoelectric film 50) so that liquid adheres more easily than foreign matter such as dust.

When the protective film 80 is made of a highly liquid-repellent material, the protective film 80 is made of a material having a contact angle of 90° or more with respect to liquid (for example, water). Moreover, when the protective film 80 is made of a highly liquid-resistant material, the protective film 80 is made of a material having a contact angle of less than 90° with a liquid (for example, water).

Furthermore, the protective film 80 is made of a material having a lower elastic modulus than the sensing section 30 (that is, the base film 70 and the piezoelectric film 50). That is, the piezoelectric element S1 detects pressure by vibrating the vibration region 22, as will be described later. For this reason, it is preferable that the protective film 80 is made of a material that does not easily block the vibration of the vibration region 22 and is made of a material that has a lower elastic modulus than that of the vibration region 22.

As described above, when the protective film 80 is made of a highly liquid-repellent material, it is made of, for example, an organic fluorine compound film. In addition, when the protective film 80 is made of a highly liquid material, it is made of, for example, a silica-based coating film, a coating film using an organic hydrophilizing agent, or a coating film such as DLC (that is, diamond-like carbon).

This protective film 80 is arranged on the side surface 10b, the bottom surface 10e of the recess 10a, and the slit 40 as follows. For example, when the protective film 80 is formed of an organic fluorine compound film, a solution is formed by using an organic fluorine compound as a solute and ethanol, hydrochloric acid, or the like as a solvent. Then, the protective film 80 is formed on the side surface 10b, the bottom surface 10e of the recess 10a, and the slit 40 by drying after applying the solution to the side surface 10b, the bottom surface 10e of the recess 10a, and the slit 40. In this case, the thickness of the protective film 80 can be appropriately changed according to the amount of solute. Specifically, the thickness of the protective film 80 increases as the amount of solute increases, and decreases as the amount of solute decreases. The protective film 80 may be formed by another method, such as coating by plasma treatment, sputtering, vapor deposition, or the like.

The above is the configuration of the piezoelectric element S1 in this embodiment.

The circuit board 2 performs predetermined processing, and includes, for example, a control unit configured by a microcomputer having a CPU, a storage section such as a ROM, a RAM, and a non-volatile RAM. The circuit board 2 is configured so that the CPU reads and executes a program from the ROM or the non-volatile RAM to execute various control operations. Specifically, the circuit board 2 detects the pressure of the medium to be measured based on the pressure detection signal. Various data (for example, initial values, lookup tables, maps, etc.) used for program execution are stored in advance in the ROM or non-volatile RAM. The storage medium such as the ROM is a non-transitory tangible storage medium. CPU is an abbreviation for Central Processing Unit, ROM is an abbreviation for Read Only Memory, RAM is an abbreviation for Random Access Memory.

As shown in FIG.1, the casing 100 includes a printed circuit board 101 on which the piezoelectric element S1 and a circuit board 2 are mounted, and a lid 102 fixed to the printed circuit board 101 in a manner to accommodate the piezoelectric element S1 and the circuit board 2. In the present embodiment, the printed circuit board 101 corresponds to a mounted member.

Although not illustrated, the printed circuit board 101 has a configuration in which a wiring portion, a through-hole electrode, and the like are appropriately formed, and electronic components such as a capacitor (not illustrated) are also mounted as necessary. In the piezoelectric element S1, the other surface 11b of the support substrate 11 is mounted on one surface 101a of the printed circuit board 101, with a bonding member 3, such as an adhesive, interposed between the other surface 11b and one surface 101a. The circuit board 2 is mounted on one surface 101a of the printed circuit board 101 via a bonding member 4 made of a conductive member. The piezoelectric element S1 and the circuit board 2 are electrically connected via a bonding wire 110. The lid 102 is made of metal, plastic, resin, or the like, and is fixed to the printed circuit board 101 to accommodate the piezoelectric element S1 and the circuit board 2, in which a bonding member, such as an adhesive (not illustrated), is interposed between the lid 102 and the circuit board 2.

Further, in the present embodiment, a through hole 101b is formed in a portion of the printed circuit board 101 that faces the vibration region 22 to allow the inside and outside of the casing 100 to communicate with each other. That is, the printed circuit board 101 is formed with a through hole 101b for introducing the medium to be measured into the recess 10a. Specifically, the through hole 101b has a substantially cylindrical shape, and is formed such that its central axis coincides with the central portion C of the vibrating portion 20 in the normal direction to one surface 101a of the printed circuit board 101.

The above is the configuration of the piezoelectric device S10 in the present embodiment. In such a piezoelectric device S10, when the medium to be measured is introduced into the recess 10a through the through hole 101b, the medium to be measured is applied to the vibration region 22 with the other surface 22b of the vibration region 22 as a pressure receiving surface, and the vibrating portion 22 vibrates according to pressure. Since the piezoelectric film 50 is deformed according to the vibration of the vibration region 22, the piezoelectric element S1 outputs a change in charge as a pressure detection signal. The piezoelectric element S1 of the present embodiment outputs a change in charge in each vibration region 22 as one pressure detection signal. Specifically, each of the vibration regions 22 has a bimorph structure, and as illustrated in FIG. 3, the lower electrode films 61, the intermediate electrode films 62, and the upper electrode films 63 formed in each vibration region 22 are connected in parallel, and the vibration regions 22 are connected in series. The piezoelectric element S1 outputs one pressure detection signal. Then, the piezoelectric device S10 detects pressure based on this pressure detection signal.

At this time, the stress generated in the vibration region 22 (that is, the piezoelectric film 50) is larger on the fixed end side than on the free end side because the stress is released on the free end side (that is, the other end portion side). That is, on the free end side, the generation of electric charges is small, and the SN ratio, which is the ratio of the signal to the noise, may tend to be small. Therefore, in the piezoelectric element S1 of the present embodiment, as described above, each vibration region 22 is divided into a first region R1 in which the stress may tend to be large and a second region R2 in which the stress may tend to be small. In the piezoelectric element S1, pressure detection signals are output from the lower electrode film 61, the upper electrode film 63, and the intermediate electrode film 62 arranged in the first region R1. As a result, the influence of noise can be prevented from increasing.

The vibration region 22 of the piezoelectric element S1 vibrates with a large amplitude when the natural frequency is excited. The natural frequency changes depending on the length from one end portion on the support region 21a side to the other end portion on the free end side, the thicknesses of the piezoelectric film 50 and the electrode film 60, materials, and the like. For this reason, it is preferable that the length of the vibration region 22, detailed materials, and the like be appropriately selected according to the intended use.

According to the present embodiment described above, the slit 40 is provided with the protective film 80. The protective film 80 is made of a material that is more liquid repellent than the sensing section 30 or a material that is more lyophilic than the sensing section 30. Therefore, when the medium to be measured is a gas, the protection film 80 is made of a highly liquid-repellent material to prevent foreign matter such as water from adhering to the slit 40, thereby preventing deterioration in detection accuracy. Further, when the medium to be measured is a liquid, the protection film 80 is made of a highly lyophilic material, so that foreign matter such as dust can be prevented from adhering to the slit 40, thereby preventing deterioration in detection accuracy.

Also, by providing the slit 40 with the protective film 80, the gap between the adjacent vibration regions 22 can be made narrower than the slit 40. Here, in the piezoelectric element S1 of the present embodiment, pressure escapes from the gaps between the vibration regions 22, and the detection accuracy tends to decrease. Therefore, by forming the protective film 80 on the slit 40, the gap between the adjacent vibration regions 22 can be narrowed, and the decrease in detection accuracy can be suppressed.

(1) In the present embodiment, the protective film 80 is also formed on the side surface 10b of the recess 10a. Therefore, it is possible to prevent foreign matter from adhering to the side surface of the recess 10a. Further, the recess 10a has the uneven portion 10c formed on the side surface 10b. Therefore, the adhesion between the protective film 80 and the uneven portion 10c can be improved. The protective film 80 is arranged so as to form the uneven structure 80a resulting from the uneven portion 10c. Therefore, compared to the case where the protective film 80 is arranged flat, the lotus effect can be exhibited, and adhesion of foreign matter can be suppressed.
(2) In the present embodiment, the protective film 80 is also formed on the other surface 22b of the vibration region 22 (that is, the bottom surface 10e of the recess 10a). Therefore, it is possible to prevent foreign matter from adhering to the other surface 22b of the vibration region 22, and to prevent the vibration of the vibration region 22 from being hindered by the foreign matter.

In the present embodiment, the protective film 80 is provided from the side surface 10b of the recess 10a to the bottom surface 10e. The protective film 80 is provided so as to fill the stepped portion 10d generated at the boundary between the support substrate 11 and the insulating film 12. Therefore, compared to the case where the protective film 80 is not arranged, it is possible to suppress the stress on the fixed end side of the vibration region 22 from becoming too large, and to suppress the breaking of the vibrating region 22.

### (Second Embodiment)

A second embodiment will be described. In the present embodiment, the shape of the recess 10a is changed from that of the first embodiment. Descriptions of the same configurations and processes as those of the first embodiment will not be repeated hereinafter.

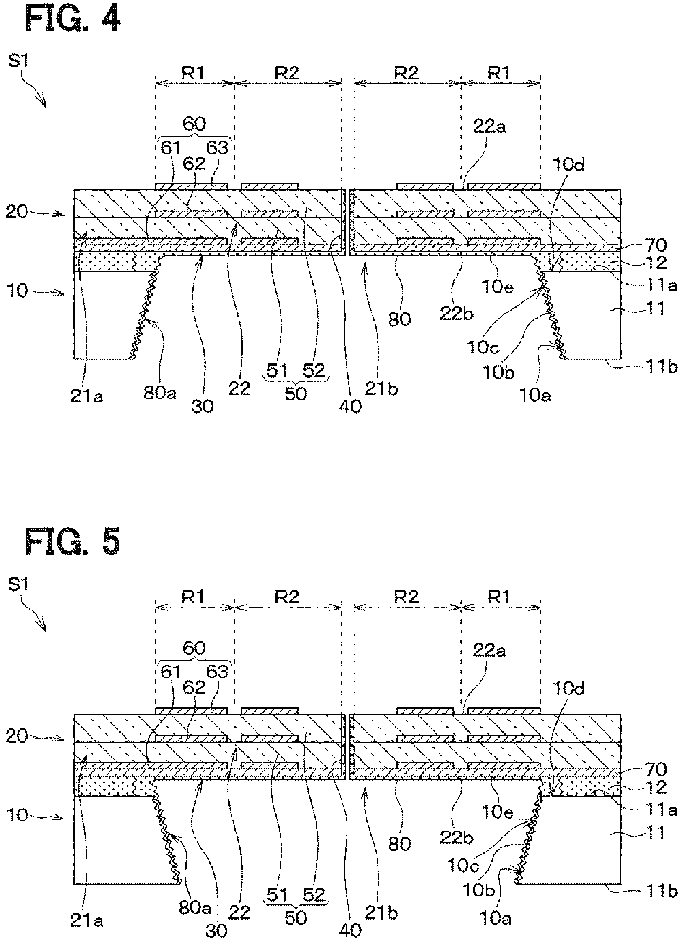

In the piezoelectric element S1 of the present embodiment, as shown in FIG. 4, the side surface 10b of the recess 10a is tapered. In the present embodiment, the side surface 10b of the recess 10a is tapered so that the distance between the side surfaces 10b facing each other increases from the vibration region 22 side toward the other surface 11b side of the support substrate 11. "From the vibration region 22 side toward the other surface 11b side of the support substrate 11" means, in other words, the direction from one surface 11a side to the other surface 11b side in the direction along the laminating direction of the support member 10 and the sensing section 30.

According to the present embodiment described above, since the protective film 80 is provided on the piezoelectric element S1, the same effects as those of the first embodiment can be obtained.

(1) In the present embodiment, the side surface 10b is tapered. For this reason, for example, when a liquid as a foreign matter adheres to the side surface 10b, compared to the case where the angle formed by the side surface 10b and the other surface 22b of the vibration region 22 is substantially perpendicular, the contact area between the liquid and the side surface 10b becomes larger. Therefore, according to the present embodiment, it is possible to easily discharge the liquid as foreign matter.

### (Modification of Second Embodiment)

The modification of the second embodiment will be described below. In the second embodiment, as shown in FIG. 5, the side surface 10b of the recess 10a has a tapered shape in which the distance between the side surfaces 10b facing each other decreases from the vibration region 22 side to the other surface 11b side of the support substrate 11. Even with such a configuration, the same effects as those of the second embodiment can be obtained.

### (Third Embodiment)

A third embodiment will be described. In the present embodiment, the protective film 80 is also provided on the casing 100 as compared with the first embodiment. Descriptions of the same configurations and processes as those of the first embodiment will not be repeated hereinafter.

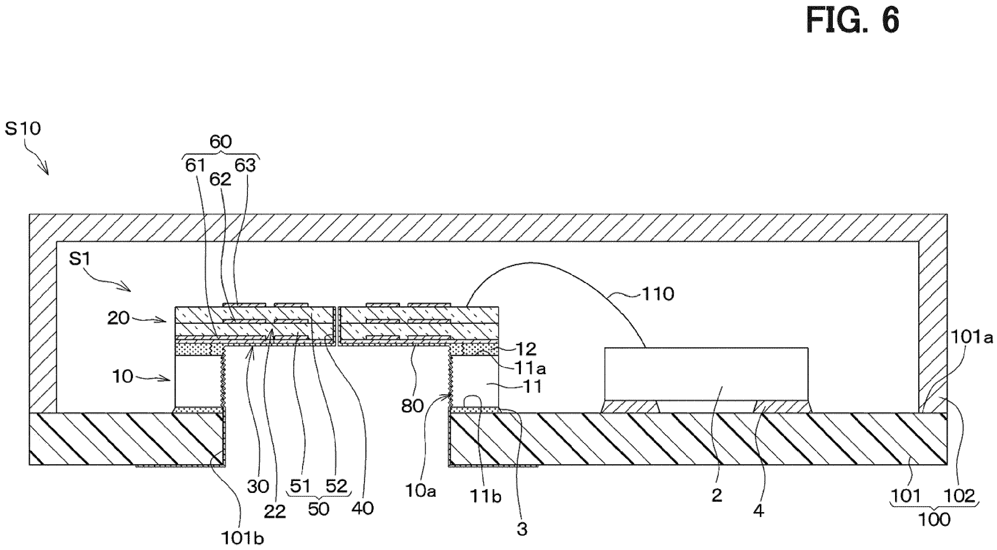

In the piezoelectric device S10 of the present embodiment, as shown in FIG. 6, the protective film 80 is formed around the through hole 101b, that is, on the wall surface of the through hole 101b and the surface of the printed circuit board 101 opposite to one surface 101a from the side surface 10b of the recess 10a.

According to the present embodiment described above, since the protective film 80 is provided on the piezoelectric element S1, the same effects as those of the first embodiment can be obtained.

(1) In the present embodiment, the protective film 80 is also provided on the wall surface of the through hole 101b through which the medium to be measured is introduced. Therefore, it is possible to prevent foreign matter from adhering to the wall surface of the through hole 101b, and to prevent the introduction of the medium to be measured through the through hole 101b from being obstructed. Moreover, such a piezoelectric device S10 can be suppressed from increasing the number of manufacturing steps by manufacturing it as follows. That is, first, the piezoelectric element S1 on which the protective film 80 is not formed is arranged on the printed circuit board 101. After that, by applying the solution to the portion where the protective film 80 of the piezoelectric element S1 is provided and the wall surface of the through hole 101b and drying it, the protective film 80 can be simultaneously formed on the piezoelectric element S1 and the wall surface of the through hole 101b, thereby suppressing an increase in the number of manufacturing steps.

### (Fourth Embodiment)

A fourth embodiment will be described. In the present embodiment, the sensor element is changed from that of the first embodiment. Descriptions of the same configurations and processes as those of the first embodiment will not be repeated hereinafter.

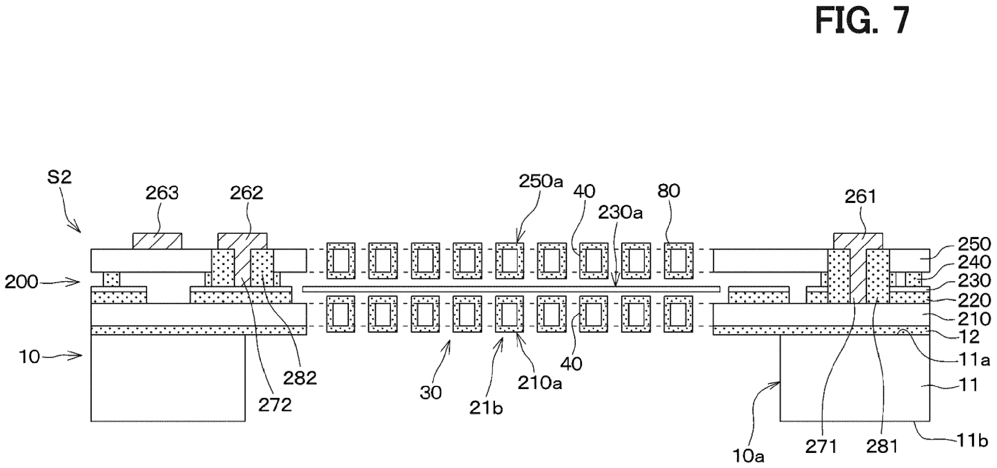

The sensor element of the present embodiment is an electrostatic pressure sensor S2, as shown in FIG. 7. Specifically, the electrostatic pressure sensor S2 has a support member 10 and a constituent layer 200 arranged on the support member 10 and forming the sensing section 30. The recess 10a is formed in the support member 10 as in the first embodiment.

The constituent layer 200 is configured by laminating a first constituent layer 210, a first insulating film 220, a second constituent layer 230, a second insulating film 240, and a third constituent layer 250. In the constituent layer 200, the portion above the recess 10a is a floating region 21b, and the sensing section 30 is configured by the floating region 21b. The first to third constituent layers 210, 230, and 250 are made of, for example, a silicon substrate, and the first and second insulating films 220, 240 are made of oxide films or the like.

The thickness of the second constituent layer 230 is adjusted so that the portion floating above the recess 10a constitutes a diaphragm portion 230a that can be displaced according to pressure.

The first and third constituent layers 210 and 250 function as the first and second electrode portions 210a and 250a that output the capacitance between them and the diaphragm portion 230a, and have a plurality of slits 40 so that the medium to be measured can pass through the diaphragm portion 230a. For this reason, the sensing section 30 of the present embodiment is also configured to have the slit 40.

The first to third pad portions 261 to 263 are arranged on the third constituent layer. Specifically, the first pad portion 261 is arranged so as to be connected to a first penetrating electrode 271 which is arranged so as to penetrate through the first insulating film 220, the second constituent layer 230, the second insulating film 240 and the third constituent layer 250 in order to be electrically connected to the first constituent layer 210. The insulating film 281 is provided around the first penetrating electrode 271 so as to provide insulation from the second constituent layer 230 and the third constituent layer 250. The second pad portion 262 is electrically connected to the second constituent layer 230 and is connected to a second penetrating electrode 272 arranged to penetrate the second insulating film 240 and the third constituent layer 250. An insulating film 282 is provided around the second penetrating electrode 272 so as to provide insulation from the third constituent layer 250. The third pad portion 263 is arranged on the third constituent layer 250.

In the present embodiment, the protective film 80 is formed so as to cover the wall surfaces forming the slits 40. In the present embodiment, in the first and third constituent layers 210 and 250, the protective film 80 is provided around the portions where the slit 40 is formed. The protective film 80 is provided so that the medium to be measured can pass through the slit 40. In other words, the protective film 80 is provided so as not to fill the slit 40.

The above is the configuration of the electrostatic pressure sensor S2 in the present embodiment. Although not shown, such an electrostatic pressure sensor S2 constitutes a sensor device in which the other surface 11b of the support substrate 11 is mounted on the printed circuit board 101 as in the first embodiment. Further, in this sensor device, the printed circuit board 101 is formed with the through hole 101b communicating with the recess 10a. In the electrostatic pressure sensor S2, when the medium to be measured is introduced into the recess 10a through the through hole 101b, the diaphragm portion 230a is displaced according to the pressure of the medium to be measured, and the distance between the diaphragm portion 230a and the first electrode portion 210a and the distance between the diaphragm portion 230a and the second electrode portion 250a change. That is, in the electrostatic pressure sensor S2, the capacitance between the diaphragm portion 230a and the first electrode portion 210a and the capacitance between the diaphragm portion 230a and the second electrode portion 250a change according to the pressure of the medium to be measured. Therefore, the electrostatic pressure sensor S2 outputs a change in capacitance as a pressure detection signal.

Also in the electrostatic pressure sensor S2, by forming the protective film 80 on the slit 40, the same effects as in the first embodiment can be obtained. Also in the present embodiment, the protective film 80 may be formed at a position including the side surface 10b of the recess 10a as in the first embodiment. In this case, the adhesion of the protective film 80 can be improved by forming the uneven portion 10c on the side surface 10b of the recess 10a. Alternatively, one surface of the diaphragm portion 230a may be used as a pressure receiving surface, and the protective film 80 may be provided on the pressure receiving surface. Furthermore, the side surface 10b of the recess 10a may be tapered as in the second embodiment.

### (Other Embodiments)

Although the present disclosure has been described in accordance with the embodiments, it is understood that the present disclosure is not limited to such embodiments or structures.

For example, in each of the above-described embodiments, the sensor element may have a polygonal shape such as a pentagonal shape or a hexagonal shape instead of a rectangular planar shape. Further, in each of the embodiments described above, the casing 100 may have the through hole 101b formed in the lid 102. In this case, for example, in the first embodiment, one surface 22a side of the vibration region 22 is the pressure receiving surface, and the protective film 80 is provided on one surface 22a of the vibration region 22.

In each of the embodiments described above, the uneven portion 10c may not be formed on the side surface 10b of the recess 10a. Further, in each of the embodiments described above, the side surface 10b of the recess 10a may be subjected to blasting or the like to form the uneven portion 10c, or the size of the uneven portion 10c may be adjusted.

Further, in the first to third embodiments, the planar shape of the floating region 21b of the piezoelectric element S1 may be polygonal such as pentagonal, hexagonal, and octagonal instead of rectangular. The number of vibration regions 22 formed in the floating region 21b can be changed as appropriate.

Furthermore, in the above-described first to third embodiments, the vibrating portion 20 may be configured to have at least one layer of the piezoelectric film 50 and one layer of the electrode film 60.

Further, each of the above embodiments may be combined as appropriate. For example, the fourth embodiment may be combined with the third embodiment, and the protective film 80 may be provided in the through hole 101b of the printed circuit board 101.

## Claims

1. A sensor element, comprising:
a support member (10) having a recess (10a); and
a sensing section (30) configured to output a detection signal corresponding to a pressure of a medium to be measured, and being disposed on the support member (10) and having a floating region (21b) formed by the recess (10a), wherein
the sensing section (30) has a slit (40) through which the medium to be measured passes is formed in a portion exposed to the medium to be measured, **characterized in that**
a protective film (80) made of a material having higher liquid repellency or higher lyophilicity than that of the sensing section (30) is provided in the slit (40) while maintaining a state in which the medium to be measured passes,
the recess (10a) has a side surface (10b) exposed to the medium to be measured,
the protective film (80) is provided on the side surface (10b),
a bottom surface (10e) of the recess (10a) is defined as a surface of the floating region (21b) of the sensing section (30) on the support member (10) side,
the protective film (80) fills a stepped portion (10d) at a boundary between the side surface (10b) and the bottom surface (10e) of the recess (10a), and
the portion of the protective film (80) located on the side surface (10b) and the portion of the protection film (80) located on the bottom surface (10e) are arranged so as to be connected more smoothly than the stepped portion (10d).

2. The sensor element according to claim 1, **characterized in that**
the recess (10a) has an uneven portion (10c) formed on the side surface (10b), and
a portion of the protective film (80) provided on the side surface (10b) has an uneven structure (80a) resulting from the uneven portion (10c).

3. The sensor element according to claim 1 or 2, **characterized in that**
the recess (10a) has a tapered shape in which a distance between the side surfaces (10b) facing each other changes along a laminating direction of the support member (10) and the sensing section (30).

4. The sensor element according to any one of claims 1 to 3, **characterized in that**
the bottom surface (10e) of the recess (10a) is configured to vibrate according to the pressure of the medium to be measured.

5. The sensor element according to any one of claims 1 to 4, **characterized in that**
the protective film (80) is made of a material having a lower elastic modulus than the sensing section (30).

6. The sensor element according to any one of claims 1 to 5, **characterized by**
a piezoelectric film (50) and an electrode film (60) electrically connected to the piezoelectric film (50), both of which are disposed on the support member (10), and
the vibrating portion (20) having a support region (21a) supported by the support member (10), and the floating region (21b), one end portion side of which is supported by the support region (21a), and the other end portion side of which is opposite to the one end portion is floating from the support member (10), wherein
the floating region (21b) has a plurality of vibration regions (22) divided by the slit (40), and
the sensing section (30) is configured to have the plurality of vibration regions (22).

7. A sensor device, comprising:
a sensor element according to any one of claims 1 to 6;
a casing (100) having a mount member (101) on which the piezoelectric element is mounted;
a lid (102) fixed to the mount member (101) while accommodating the piezoelectric element; and
a through hole (101b) configured to communicate with an outside of the piezoelectric element to introduce the medium to be measured, wherein
the protective film (80) is provided on a wall surface of the through hole (101b).

## Patentansprüche

1. Sensorelement, aufweisend:
ein Tragelement (10) mit einer Vertiefung (10a); und
einen Messabschnitt (30), der konfiguriert ist, um ein Erfassungssignal entsprechend einem Druck eines zu messenden Mediums auszugeben, und der auf dem Tragelement (10) angeordnet ist und einen Schwebebereich (21b) hat, der durch die Vertiefung (10a) ausgebildet ist, wobei
der Messabschnitt (30) einen Schlitz (40) hat, durch den das zu messende Medium passiert, und in einem Abschnitt ausgebildet ist, der dem zu messenden Medium ausgesetzt ist, **dadurch gekennzeichnet, dass**
ein Schutzfilm (80), der aus einem Material hergestellt ist, das ein höheres Flüssigkeitsabweisungsvermögen oder eine höhere Lipophilie als das des Messabschnitts (30) hat, in dem Schlitz (40) vorgesehen ist, während ein Zustand aufrechterhalten wird, in dem das zu messende Medium passiert,
die Vertiefung (10a) eine Seitenoberfläche (10b) hat, die dem zu messenden Medium ausgesetzt ist,
der Schutzfilm (80) auf der Seitenoberfläche (10b) vorgesehen ist,
eine Bodenoberfläche (10e) der Vertiefung (10a) als eine Oberfläche des Schwebebereichs (21b) des Messabschnitts (30) auf der Seite des Tragelements (10) definiert ist,
der Schutzfilm (80) einen gestuften Abschnitt (10d) an einer Grenze zwischen der Seitenoberfläche (10b) und der Bodenoberfläche (10e) der Vertiefung (10a) füllt, und
der Abschnitt des Schutzfilms (80), der sich auf der Seitenoberfläche (10b) befindet, und der Abschnitt des Schutzfilms (80), der sich auf der Bodenoberfläche (10e) befindet, so angeordnet sind, dass sie glatter verbunden sind als der gestufte Abschnitt (10d).

2. Sensorelement gemäß Anspruch 1, **dadurch gekennzeichnet, dass**
die Vertiefung (10a) einen unebenen Abschnitt (10c) hat, der auf der Seitenoberfläche (10b) ausgebildet ist, und
ein Abschnitt des Schutzfilms (80), der auf der Seitenoberfläche (10b) vorgesehen ist, eine unebene Struktur (80a) hat, die sich aus dem unebenen Abschnitt (10c) ergibt.

3. Sensorelement gemäß Anspruch 1 oder 2, **dadurch gekennzeichnet, dass**
die Vertiefung (10a) eine sich verjüngende Form hat, in der sich eine Distanz zwischen den Seitenoberflächen (10b), die einander zugewandt sind, entlang einer Laminierrichtung des Tragelements (10) und des Messabschnitts (30) ändert.

4. Sensorelement gemäß einem der Ansprüche 1 bis 3, **dadurch gekennzeichnet, dass**
die Bodenoberfläche (10e) der Vertiefung (10a) konfiguriert ist, um gemäß dem Druck des zu messenden Mediums zu vibrieren.

5. Sensorelement gemäß einem der Ansprüche 1 bis 4, **dadurch gekennzeichnet, dass**
der Schutzfilm (80) aus einem Material hergestellt ist, dessen Elastizitätsmodul niedriger als der des Messabschnitts (30) ist.

6. Sensorelement gemäß einem der Ansprüche 1 bis 5, **gekennzeichnet durch**
einen piezoelektrischen Film (50) und einen Elektrodenfilm (60), der elektrisch mit dem piezoelektrischen Film (50) verbunden ist, die beide auf dem Tragelement (10) angeordnet sind,
und
den Vibrationsabschnitt (20), der einen Tragbereich (21a), der durch das Tragelement (10) getragen wird, und den Schwebebereich (21b) hat, dessen eine Endabschnittsseite durch den Tragbereich (21a) getragen wird und dessen andere Endabschnittsseite, die dem einen Endabschnitt gegenüberliegt, von dem Tragelement (10) freischwebend ist, wobei
der Schwebebereich (21b) eine Vielzahl von Vibrationsbereichen (22) hat, die durch den Schlitz (40) unterteilt sind, und
der Messabschnitt (30) konfiguriert ist, um die Vielzahl von Vibrationsbereichen (22) zu haben.

7. Sensorvorrichtung, aufweisend:
ein Sensorelement gemäß einem der Ansprüche 1 bis 6;
ein Gehäuse (100) mit einem Montageelement (101), auf dem das piezoelektrische Element montiert ist;
einen Deckel (102), der an dem Montageelement (101) fixiert ist, während er das piezoelektrische Element aufnimmt; und
ein Durchgangsloch (101b), das konfiguriert ist, um mit einer Außenseite des piezoelektrischen Elements zu kommunizieren, um das zu messende Medium einzuführen, wobei
der Schutzfilm (80) auf einer Wandoberfläche des Durchgangslochs (101b) vorgesehen ist.

## Revendications

1. Élément de capteur, comprenant :
un organe de support (10) présentant un évidement (10a) ; et
une section de détection (30) configurée pour émettre un signal de détection correspondant à une pression d'un milieu à mesurer, et étant disposée sur l'organe de support (10) et présentant une région flottante (21b) formée par l'évidement (10a), dans lequel
la section de détection (30) présente une fente (40) à travers laquelle le milieu à mesurer passe est formée dans une portion exposée au milieu à mesurer,
**caractérisé en ce que**
un film protecteur (80) constitué d'un matériau présentant une répulsion aux liquides ou une lyophilicité plus élevée que celle de la section de détection (30) est fourni dans la fente (40) tout en maintenant un état dans lequel le milieu à mesurer passe,
l'évidement (10a) présente une surface latérale (10b) exposée au milieu à mesurer,
le film protecteur (80) est fourni sur la surface latérale (10b), une surface inférieure (10e) de l'évidement (10a) est définie en tant que surface de la région flottante (21b) de la section de détection (30) sur le côté d'organe de support (10),
le film protecteur (80) remplit une portion étagée (10d) à une limite entre la surface latérale (10b) et la surface inférieure (10e) de l'évidement (10a), et
la portion du film protecteur (80) située sur la surface latérale (10b) et la portion du film protecteur (80) située sur la surface inférieure (10e) sont agencées de manière à être connectées plus facilement que la portion étagée (10d).

2. Élément de capteur selon la revendication 1, **caractérisé en ce que**
l'évidement (10a) présente une portion inégale (10c) formée sur la surface latérale (10b), et
une portion du film protecteur (80) fournie sur la surface latérale (10b) présente une structure inégale (80a) résultant de la portion inégale (10c).

3. Élément de capteur selon la revendication 1 ou 2, **caractérisé en ce que**
l'évidement (10a) présente une forme conique dans laquelle une distance entre les surfaces latérales (10b) se faisant face change le long d'une direction de stratification de l'organe de support (10) et de la section de détection (30).

4. Élément de capteur selon l'une quelconque des revendications 1 à 3, **caractérisé en ce que**
la surface inférieure (10e) de l'évidement (10a) est configurée pour vibrer selon la pression du milieu à mesurer.

5. Élément de capteur selon l'une quelconque des revendications 1 à 4, **caractérisé en ce que**
le film protecteur (80) est constitué d'un matériau présentant un module d'élasticité inférieur à la section de détection (30).

6. Élément de capteur selon l'une quelconque des revendications 1 à 5, **caractérisé par**
un film piézoélectrique (50) et un film d'électrode (60) électriquement connecté au film piézoélectrique (50), tous deux disposés sur l'organe de support (10), et
la portion vibrante (20) présentant une région de support (21a) supportée par l'organe de support (10), et la région flottante (21b), dont un côté de portion d'extrémité est supporté par la région d'appui (21a), et dont l'autre côté de portion d'extrémité qui est opposé à l'une portion d'extrémité est flottant par rapport à l'organe de support (10), dans lequel
la région flottante (21b) présente une pluralité de régions de vibration (22) divisées par la fente (40), et
la section de détection (30) est configurée pour présenter la pluralité de régions de vibration (22).

7. Dispositif de détection, comprenant :
un élément de capteur selon l'une quelconque des revendications 1 à 6 ;
un boîtier (100) présentant un organe de montage (101) sur lequel l'élément piézoélectrique est monté ;
un couvercle (102) fixé à l'organe de montage (101) tout en accueillant l'élément piézoélectrique ; et
un trou traversant (101b) configuré pour communiquer avec un extérieur de l'élément piézoélectrique pour introduire le milieu à mesurer, dans lequel
le film protecteur (80) est fourni sur une surface de paroi du trou traversant (101b).
